# EUROPEAN PATENT SPECIFICATION

(11) **EP 4 514 078 B1**
(45) Date of publication and mention of the grant of the patent: **25.11.2026**
(21) Application number: 23851693.4
(22) Date of filing: 03.08.2023
(51) Int. Cl.: H05K 5/02

(54) **HOUSING, WEARABLE DEVICE AND PREPARATION METHOD**
GEHÄUSE, TRAGBARE VORRICHTUNG UND HERSTELLUNGSVERFAHREN
BOÎTIER, DISPOSITIF HABITRONIQUE ET PROCÉDÉ DE PRÉPARATION

(30) Priority: 12.08.2022 CN 202210968025
(43) Date of publication of application: 26.02.2025
(73) Proprietor: Huawei Technologies Co., Ltd., Shenzhen, Guangdong 518129 (CN)
(72) Inventor: YANG, Rongguang, Shenzhen, Guangdong 518129 (CN); ZHAO, Menglong, Shenzhen, Guangdong 518129 (CN); ZOU, Lin, Shenzhen, Guangdong 518129 (CN); DU, Zhongpei, Shenzhen, Guangdong 518129 (CN)
(74) Representative: Goddar, Heinz J.
(86) International application number: PCT/CN2023/111075
(87) International publication number: WO 2024/032472

(56) References cited:
- CN-A- 105 162 908
- CN-A- 110 785 035
- CN-A- 114 478 001
- CN-U- 204 408 794
- KR-U- 20150 002 449
- US-A1- 2012 212 890
- US-A1- 2022 108 833

## Description

This application claims priority to Chinese Patent Application No. 202210968025.5, filed with the China National Intellectual Property Administration on August 12, 2022 and entitled "HOUSING, WEARABLE DEVICE, AND PREPARATION METHOD".

### TECHNICAL FIELD

Embodiments of this application relate to the field of terminal technologies, and in particular, to a housing, a wearable device, and a preparation method.

### BACKGROUND

A wearable device is generally a portable device that may be worn on a user, a shoe or clothing, or another accessory. In addition, the wearable device may be used independently, or may be used as a portable accessory of a mobile terminal, for example, a wearable device like a smartwatch or a band.

In the conventional technology, to enable the wearable device to have a wireless charging function, a wireless charging coil is disposed in a housing of the wearable device, and the wireless charging coil is electrically connected to a host circuit in the wearable device. The housing includes a ceramic bottom housing, a plastic inner housing, and the wireless charging coil sandwiched between the ceramic bottom housing and the plastic inner housing.

An example of housing is given in US 2022/108833 A1.

However, an existing housing is thick, which reduces user experience of using the wearable device.

### SUMMARY

Embodiments of this application provide a housing, a wearable device, and a preparation method. A thickness of a charging coil and/or a thickness of a ceramic bottom housing, and a thickness of a plastic inner housing are reduced, so that a thickness of the housing can be reduced. This helps improve user experience of using the wearable device.

A first aspect of embodiments of this application provides a housing, including at least a ceramic bottom housing, a charging coil, a plastic inner housing, a nanocrystalline film, and a protective film. The charging coil is disposed on an inner side of the ceramic bottom housing, and the charging coil is a printed coil and is sintered with the ceramic bottom housing into an integrated structure. The nanocrystalline film covers a surface of the charging coil and is securely connected to the charging coil. The protective film covers a surface of the nanocrystalline film and is securely connected to the nanocrystalline film, and the protective film is configured to prevent the nanocrystalline film from being damaged in a process of forming the plastic inner housing through injection molding. The plastic inner housing is formed on an inner side surface of the ceramic bottom housing through nano injection molding and covers the protective film, so that the plastic inner housing, the ceramic bottom housing, and the protective film are of an integrated structure.

In the housing that can be used as a housing of a wearable device and that is provided in embodiments of this application, the charging coil is a printed coil, so that a thickness of the charging coil can be reduced. The charging coil and the ceramic bottom housing are sintered into an integrated structure, so that a thickness obtained after the charging coil and the ceramic bottom housing are assembled can be further reduced. Therefore, a thickness of the housing can be reduced. The nanocrystalline film covers the charging coil, so that an eddy current caused by magnetic resistance of the charging coil during electromagnetic induction can be improved, and charging efficiency of the wearable device can be improved. The protective film covers the surface of the nanocrystalline film, so that a bottom housing assembly formed after the ceramic bottom housing, the charging coil, the nanocrystalline film, and the protective film are assembled may be placed into a mold, and the plastic inner housing that is of an integrated structure with the bottom housing assembly is directly formed on the protective film and an inner surface of the ceramic bottom housing through nano injection molding. This can reduce a thickness of the plastic inner housing. In addition, in combination with the printed coil that is sintered with the ceramic bottom housing into an integrated structure, the thickness of the housing can be further reduced, so that the thickness of the housing is significantly reduced. The protective film may prevent the nanocrystalline film from being damaged by a high-temperature and high-pressure plastic liquid in an injection molding process, and nano injection molding may be directly performed on the bottom housing assembly to form the plastic inner housing. In addition, because the plastic inner housing separately forms an integrated structure with the protective film and the ceramic bottom housing, this helps increase a bonding force between the plastic inner housing and the ceramic bottom housing, and can improve waterproof performance of the wearable device.

In a possible implementation, the ceramic bottom housing is a ceramic bottom housing formed through hot bending of a ceramic piece. The ceramic bottom housing is a ceramic piece formed through hot bending. In one aspect, a thickness of the ceramic bottom housing can be reduced, so that the thickness of the housing can be reduced. In another aspect, production time of the ceramic bottom housing can be reduced. Therefore, the ceramic bottom housing formed through hot bending of the ceramic piece is used, so that the thickness of the housing can be reduced. This helps improve user experience of using the wearable device.

In a possible implementation, a material of the charging coil is nano-silver paste or conductive ceramic. When a material of the printed coil is the conductive ceramic, the printed coil is insulated from the ceramic bottom housing.

In a possible implementation, the protective film is a metal film, or the protective film is a non-metal film made of plastic or fiber.

In a possible implementation, a mating portion is disposed on the plastic inner housing, a clamping portion is extendedly disposed at an edge of the inner side surface of the ceramic bottom housing, and the clamping portion is clamped to the mating portion. The charging coil is disposed on the inner side surface of the ceramic bottom housing.

In a possible implementation, the clamping portion and the inner side surface of the ceramic bottom housing jointly define a first stepped surface, and the mating portion is a clamping groove for inserting the clamping portion.

In a possible implementation, a protruding portion is extendedly disposed in the middle of the inner side surface of the ceramic bottom housing, and the protruding portion and the inner side surface of the ceramic bottom housing jointly define a second stepped surface. The charging coil is disposed on the inner side surface of the ceramic bottom housing and is disposed close to the second stepped surface.

In a possible implementation, the housing further includes a transparent cover plate. A mounting through hole that penetrates the ceramic bottom housing is disposed in the middle of the ceramic bottom housing, a third stepped surface is defined on an inner wall of the mounting through hole, and the transparent cover plate is mounted on the third stepped surface.

In a possible implementation, the ceramic bottom housing includes a connecting portion and a transparent portion. A material of the connecting portion is a non-transparent ceramic material, and the transparent portion is transparent ceramic and is sintered with the connecting portion into an integrated structure.

In a possible implementation, the transparent portion includes a first transparent portion and an annular second transparent portion. The first transparent portion is located in the second transparent portion, and an annular gap for accommodating a part of the connecting portion is defined between the first transparent portion and the second transparent portion.

A second aspect of embodiments of this application provides a housing, including at least a ceramic bottom housing, a charging coil, and a plastic inner housing. The ceramic bottom housing is a ceramic bottom housing formed through hot bending of a ceramic piece. The charging coil is fastened to an inner side of the ceramic bottom housing. The plastic inner housing covers a surface of the charging coil and contacts an inner side surface of the ceramic bottom housing, and the plastic inner housing is securely connected to the ceramic bottom housing. The charging coil is a conductive coil formed by winding a metal wire.

A third aspect of this application provides a wearable device, including a conductive member and the housing according to any one of the foregoing implementations, where a charging coil of the housing is electrically connected to a host circuit of the wearable device via the conductive member.

In a possible implementation, the conductive member is a conductive silica gel or elastomer.

A fourth aspect of this application provides a method for preparing a housing, including:
forming, on an inner surface of a ceramic bottom housing, a charging coil that is of an integrated structure with the ceramic bottom housing;
covering a surface of the charging coil having the ceramic bottom housing with a nanocrystalline film;
covering a surface of the nanocrystalline film having the charging coil with a protective film, to form a bottom housing assembly; and
placing the bottom housing assembly having the protective film into a mold for nano injection molding, to form a plastic inner housing that is of an integrated structure with the protective film and the ceramic bottom housing.

In a possible implementation, the forming, on an inner surface of a ceramic bottom housing, a charging coil that is of an integrated structure with the ceramic bottom housing includes:
providing a conductive slurry;
coating the conductive slurry on the inner surface of the ceramic bottom housing by using a printing process, to form the charging coil on the ceramic bottom housing; and
sintering the ceramic bottom housing having the charging coil, so that the charging coil and the ceramic bottom housing form an integrated structure.

In a possible implementation, the conductive slurry is nano-silver paste or conductive ceramic.

In a possible implementation, the printing process includes any one of the following processes: a screen printing process, a pad printing process, a 3D printing process, a sticker printing process, and a yellow light developing process.

In a possible implementation, before the forming, on an inner surface of a ceramic bottom housing, a charging coil that is of an integrated structure with the ceramic bottom housing, the method further includes:
preparing the ceramic bottom housing formed through hot bending.

In a possible implementation, the preparing the ceramic bottom housing formed through hot bending includes:
providing a ceramic piece having an equal thickness;
preparing a stepped structure on the ceramic piece; and
performing hot bending processing on the ceramic piece having the stepped structure to form the ceramic bottom housing.

In a possible implementation, the preparing a stepped structure on the ceramic piece includes:
forming a first annular groove on a bottom surface of the ceramic piece, where a first stepped surface and a second stepped surface that are spaced along a radial direction are formed on an inner wall of the first annular groove, and the second stepped surface is disposed close to an axis of the first annular groove; and
forming a mounting through hole that penetrates the ceramic piece, where the mounting through hole is located in the first annular groove and is disposed close to the second stepped surface, and a third stepped surface is defined on an inner wall of the mounting through hole.

In a possible implementation, the preparing a stepped structure on the ceramic piece includes:
forming a second annular groove on a bottom surface of the ceramic piece, where a first stepped surface and a second stepped surface that are spaced along a radial direction are formed on an inner wall of the second annular groove, and the second stepped surface is disposed close to an axis of the second annular groove.

In a possible implementation, the providing a ceramic piece having an equal thickness includes:
providing a non-transparent ceramic substrate, a circular first transparent ceramic piece, and an annular second transparent ceramic piece;
forming a first through hole and an annular second through hole that penetrate the ceramic substrate, where the first through hole is located in the second through hole;
filling the first transparent ceramic piece in the first through hole;
filling the second transparent ceramic piece in the second through hole; and
sintering the first transparent ceramic piece, the second transparent ceramic piece, and the ceramic substrate to form the ceramic piece of an integrated structure.

### BRIEF DESCRIPTION OF DRAWINGS

FIG. 1 is a partial exploded view of a wearable device;
FIG. 2 is a sectional view of a housing according to an embodiment of this application;
FIG. 3 is a partial enlarged diagram of the embodiment shown in FIG. 2;
FIG. 4 is a partial enlarged diagram of a position A in FIG. 3;
FIG. 5 is a sectional view of a ceramic bottom housing according to an embodiment of this application;
FIG. 6 is a sectional view of another ceramic bottom housing according to an embodiment of this application;
FIG. 7 is a sectional view of still another ceramic bottom housing according to an embodiment of this application;
FIG. 8 is a sectional view of yet another ceramic bottom housing according to an embodiment of this application;
FIG. 9 is a sectional view of still yet another ceramic bottom housing according to an embodiment of this application;
FIG. 10 is a flowchart of a method for preparing a housing according to an embodiment of this application;
FIG. 11 is a diagram of a preparation process of the preparation method shown in FIG. 10;
FIG. 12 is a flowchart of a method for preparing a printed coil according to an embodiment of this application;
FIG. 13 is a partial sectional view of another housing according to an embodiment of this application;
FIG. 14 is a partial three-dimensional diagram of still another housing according to an embodiment of this application;
FIG. 15 is a front view of the housing shown in FIG. 14;
FIG. 16 is a flowchart of a method for preparing another housing according to an embodiment of this application;
FIG. 17 is a diagram of a preparation process of the preparation method shown in FIG. 16;
FIG. 18 is a flowchart of a preparation method for preparing a ceramic bottom housing formed through hot bending according to an embodiment of this application;
FIG. 19 is a flowchart of a preparation method for preparing a ceramic piece having transparent ceramic according to an embodiment of this application;
FIG. 20 is a diagram of a preparation process of the preparation method shown in FIG. 19;
FIG. 21 is a diagram of a process of preparing a stepped structure according to an embodiment of this application;
FIG. 22 is a diagram of a process of preparing another stepped structure according to an embodiment of this application; and
FIG. 23 is a preparation diagram of performing hot pressing processing on a ceramic piece having a stepped structure according to an embodiment of this application.

Descriptions of reference numerals:
1000: wearable device;
100: housing;
110: ceramic bottom housing;
111: protruding portion;
112: clamping portion;
113: first stepped surface;
114: mounting through hole;
115: third stepped surface;
116: connecting portion; 1161: first connecting portion; 1162: second connecting portion;
117: transparent portion; 1171: first transparent portion; 1172: second transparent portion;
118: second stepped surface;
120: charging coil; 130: nanocrystalline film; 140: protective film;
150: plastic inner housing; 151: mating portion;
300: transparent cover plate;
410: top cover; 420: ceramic bottom cover; 430: wireless charging coil;
50: bottom housing assembly;
510: ceramic matrix;
600: ceramic piece; 610: ceramic substrate; 620: first through hole; 630: second through hole; 640: first transparent ceramic piece; 650: second transparent ceramic piece; 660: first annular groove; and 670: second annular groove.

### DESCRIPTION OF EMBODIMENTS

A wearable device 1000 is a portable device that may be worn on a user, a shoe or clothing, or another accessory. The wearable device 1000 may be used independently or in cooperation with a mobile terminal. For example, the wearable device 1000 may be an electronic product like a smartwatch, a watch, a smart band, or a band. In embodiments of this application, an example in which the wearable device 1000 is a smartwatch is used for description.

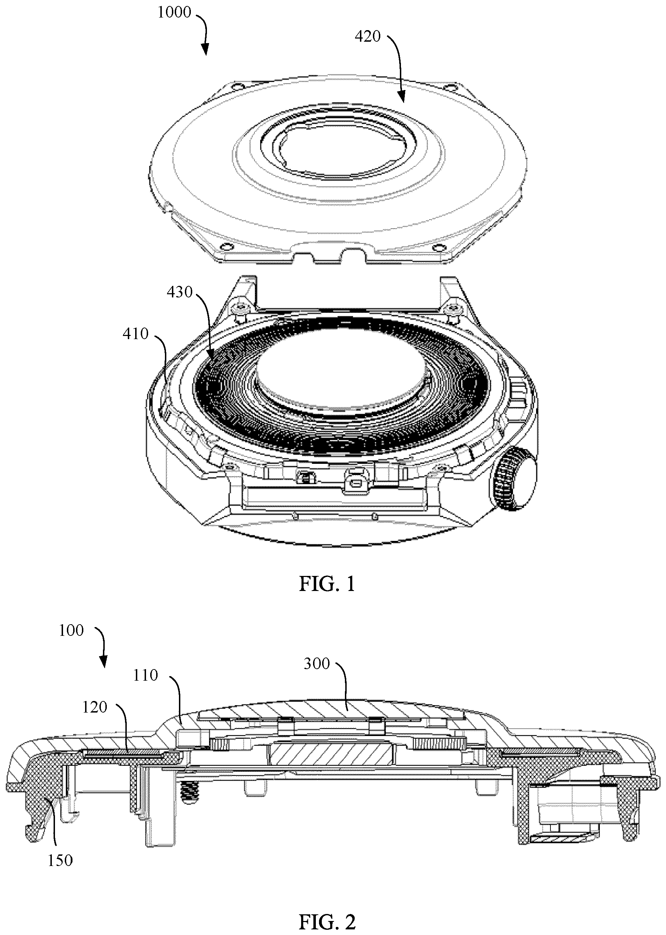

FIG. 1 is a partial exploded view of the wearable device 1000. The wearable device 1000 includes a watch face and a watch band (not shown in the figure) connected to the watch face. Refer to FIG. 1. The watch face includes at least a top cover 410, a ceramic bottom cover 420, and a wireless charging coil 430. The top cover 410 covers the ceramic bottom cover 420 and is securely connected to the ceramic bottom cover 420. The top cover 410 and the ceramic bottom cover 420 define a cavity. The wireless charging coil 430 is located in the cavity. The wireless charging coil 430 is configured to implement a wireless charging function of the wearable device 1000.

In the conventional technology, the wearable device 1000 further includes a plastic inner housing 150, and the wireless charging coil 430 is located between the ceramic bottom cover 420 and the plastic inner housing 150 and is clamped by the plastic inner housing 150 and the ceramic bottom cover 420. However, because the wireless charging coil 430 is a conductive coil formed by winding a metal wire, the wireless charging coil 430 is thick, and a thickness of a component formed after the wireless charging coil 430, the ceramic bottom cover 420, and the plastic inner housing 150 are assembled increases. As a result, an overall thickness of the wearable device 1000 increases, and user experience is reduced. In addition, due to the wireless charging coil 430, a bonding force between the plastic inner housing 150 and the ceramic bottom cover 420 is reduced, and waterproof performance of the wearable device 1000 is affected. In addition, to improve charging efficiency of the wireless charging coil 430, a nanocrystalline film 430 may be covered on a surface of the wireless charging coil 120. Because the nanocrystalline film 130 is located between the wireless charging coil 430 and the plastic inner housing 150, injection molding cannot be directly performed on an inner side of a ceramic bottom housing 110 to form the plastic inner housing 150 that is of an integrated structure with the ceramic bottom housing 110. As a result, a processing process of the plastic inner housing 150 is limited.

In view of this, an embodiment of this application provides a wearable device 1000. The wearable device 1000 includes at least a housing 100. The housing 100 may include a ceramic bottom housing 110, a charging coil 120, and a plastic inner housing 150150. The charging coil 120 is disposed on an inner side surface of the ceramic bottom housing 110, the plastic inner housing 150130 covers a surface of the charging coil 120 and is securely connected to the ceramic bottom housing 110. In this embodiment of this application, a thickness of the housing 100 can be reduced by reducing at least one of a thickness of the ceramic bottom housing 110, a thickness of the charging coil 120, and a thickness of the plastic inner housing 150. In addition, in this embodiment of this application, a protective film 140 is disposed on a surface of a nanocrystalline film 130, nano injection molding can be performed on a surface of the protective film 140, and in an injection molding process, the protective film 140 can prevent the nanocrystalline film 130 from being damaged by a high-temperature and high-pressure plastic liquid. In this way, the plastic inner housing 150 that is of an integrated structure with the protective film 140 and the ceramic bottom housing 110 is formed. Such disposition helps increase a bonding force between the ceramic housing 100 and the plastic inner housing 150, and can reduce the thickness of the plastic inner housing 150, thereby helping further reduce the thickness of the housing 100.

A manner of reducing the thickness of the housing 100 may include but is not limited to the following several manners: 1. The thickness of the ceramic bottom housing 110, the thickness of the charging coil 120, or the thickness of the plastic inner housing 150 may be reduced. 2. The thickness of the ceramic bottom housing 110 and the thickness of the charging coil 120 are reduced. 3. The thickness of the charging coil 120 and the thickness of the plastic inner housing 150 are reduced. 4. The thickness of the ceramic bottom housing 110 and the thickness of the plastic inner housing 150 are reduced. 5. The thickness of the ceramic bottom housing 110, the thickness of the charging coil 120, and the thickness of the plastic inner housing 150 are reduced.

The wearable device 1000 provided in this embodiment of this application may further include a conductive member. The charging coil 120 may be electrically connected to a host circuit of the wearable device 1000 via the conductive member, so that the wearable device 1000 can be wirelessly charged. The conductive member may be a structure like a conductive silica gel or elastomer. This is not specifically limited herein.

The following describes a housing 100 provided in an embodiment of this application and a method for preparing the housing 100.

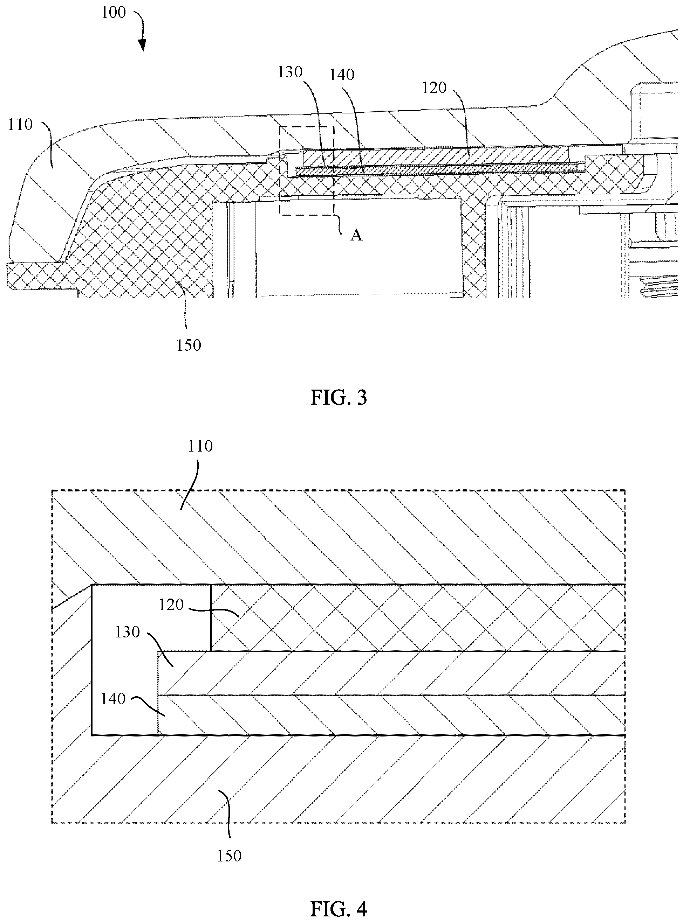

FIG. 2 is a sectional view of the housing 100 according to an embodiment of this application. FIG. 3 is a partial enlarged diagram of the embodiment shown in FIG. 2, and FIG. 4 is a partial enlarged diagram of a position A in FIG. 3.

Refer to FIG. 2 to FIG. 4. The housing 100 provided in this embodiment of this application includes at least a charging coil 120, a plastic inner housing 150, a nanocrystalline film 130, and a protective film 140. The charging coil 120 is disposed on an inner side of a ceramic bottom housing 110, and the charging coil 120 is a printed coil and is sintered with the ceramic bottom housing 110 into an integrated structure. The printed coil is a printed coil circuit formed in a predetermined region on an inner surface of the ceramic bottom housing 110 by using a printing process, and the printed coil can implement a wireless charging function of the wearable device 1000. Because the printed coil is a printed circuit with a thin thickness, a thickness of the charging coil 120 using the printed coil is significantly less than that of a charging coil 120 formed by winding a metal wire, so that a thickness of the housing 100 can be reduced. The printed coil and the ceramic bottom housing 110 are sintered into an integrated structure, which helps reduce a thickness of the charging coil 120 and the ceramic bottom housing 110 after assembly, and can further increase a bonding force between the charging coil 120 and the ceramic bottom housing 110.

A shape of the charging coil 120 may be flexibly adjusted based on a shape of an inner side surface of the ceramic bottom housing 110. This is not specifically limited in embodiments of this application. For example, the shape of the charging coil 120 may be a circle, a square, an ellipse, or the like. In addition, the printing process may be a screen printing process, a pad printing process, a 3D printing process, a sticker printing and transfer printing process, a yellow light developing process, or the like. This is not specifically limited herein. It should be noted that a corresponding printing process may be selected based on a use requirement or a structure of the ceramic bottom housing 110. For example, when a surface on which coils are arranged on the ceramic bottom housing 110 is a concave surface or an arc surface, the 3D printing process may be used, so that line density of the charging coil 120 can be improved. The line density refers to a distance between two adjacent coils of the charging coil 120. Alternatively, to obtain a fine charging coil 120, the charging coil 120 may be printed by using the yellow light developing process.

Refer to FIG. 3 and FIG. 4. The nanocrystalline film 130 covers a surface of the charging coil 120 and is securely connected to the charging coil 120. The nanocrystalline film 130 can improve an eddy current caused by magnetic resistance of the charging coil 120 during electromagnetic induction, to improve charging efficiency of the wearable device 1000. In some examples, the nanocrystalline film 130 may be securely connected to the charging coil 120 in a bonding manner. In addition, a shape of the nanocrystalline film 130 may be a circular or polygonal plate structure. An area of the nanocrystalline film 130 may be greater than or equal to an area of the charging coil 120, so that the surface of the charging coil 120 can be covered. The surface of the charging coil 120 is a surface that is of the charging coil 120 and that is away from the ceramic bottom housing 110.

It should be noted that, when the area of the nanocrystalline film 130 is greater than the area of the charging coil 120, a gap may exist between the plastic inner housing 150 and a side wall of the charging coil 120 in a process of forming the plastic inner housing 150 through nano injection molding, to prevent a plastic liquid used for nano injection molding from impacting the charging coil 120.

Refer to FIG. 3 and FIG. 4. The protective film 140 covers a surface of the nanocrystalline film 130 and is securely connected to the nanocrystalline film 130. The surface of the nanocrystalline film 130 is a surface that is of the nanocrystalline film 130 and that is away from the charging coil 120. In some examples, the protective film 140 may be securely connected to the nanocrystalline film 130 in a bonding manner. Certainly, a manner of connection between the protective film 140 and the nanocrystalline film 130 is not limited to bonding. A shape of the protective film 140 may be a circular or polygonal plate structure. For example, in this embodiment of this application, the protective film 140 is an annular plate structure. An area of the protective film 140 may be greater than or equal to the area of the nanocrystalline film 130, so that the nanocrystalline film 130 can be covered. In this way, in the nano injection molding process of forming the plastic inner housing 150, the protective film 140 can prevent the nanocrystalline film 130 from being damaged by a high-temperature and high-pressure plastic liquid, and it is avoided that the nanocrystalline film 130 cannot improve the eddy current caused by magnetic resistance of the charging coil 120 during electromagnetic induction.

Refer to FIG. 3 and FIG. 4. The plastic inner housing 150 covers a surface of the protective film 140, and the plastic inner housing 150 further contacts the inner side surface of the ceramic bottom housing 110. In addition, the plastic inner housing 150 is formed on the inner side surface of the ceramic bottom housing 110 through nano injection molding and covers the surface of the protective film 140, so that the plastic inner housing 150, the protective film 140, and the ceramic bottom housing 110 are of an integrated structure. The surface of the protective film 140 is a surface that is of the protective film 140 and that is away from the nanocrystalline film 130. Because of the protective film 140, nano injection molding may be directly performed on the ceramic bottom housing 110, to form the plastic inner housing 150 that is of an integrated structure with the ceramic bottom housing 110 and the protective film 140. In one aspect, a thickness of the plastic inner housing 150 can be reduced, so that the thickness of the housing 100 can be reduced. In another aspect, a bonding force between the ceramic bottom housing 110 and the plastic inner housing 150 can be increased, which helps improve waterproof performance of the wearable device 1000.

It may be understood that, because of the protective film 140, a manner of securing the ceramic bottom housing 110 and the plastic inner housing 150 also increases, so that the ceramic bottom housing 110 is not limited to being assembled with the plastic inner housing 150 in a bonding manner.

In conclusion, in the housing 100 provided in this embodiment of this application, the printed coil is used as the charging coil 120 and is sintered with the ceramic bottom housing 110 into an integrated structure, and nano injection molding is performed on the protective film 140 to form the plastic inner housing 150 that is of an integrated structure with the ceramic bottom housing 110 and the protective film 140. In one aspect, the thickness of the housing 100 can be reduced, and user experience of using the wearable device 1000 can be improved. In another aspect, the bonding force between the ceramic bottom housing 110 and the plastic inner housing 150 can be increased, which helps improve the waterproof performance of the wearable device 1000.

In some possible implementations, a material of the charging coil 120 may be nano-silver paste or conductive ceramic. It should be noted that, resistivity of pure silver is 1.65×10⁻⁸ Ω.M. The nano-silver paste and the ceramic bottom housing 110 are firmly combined after being co-sintered at a high temperature, and resistivity of the charging coil 120 may slightly increase and is close to resistivity of copper: 1.7×10⁻⁸ Ω.M. A line width, a thickness, and a total length of the charging coil 120 are adjusted, so that it can be ensured that a designed quantity of coils is reached in specific space, and a resistance value required by a wireless charging function is met, for example, a resistance value required by a wireless charging function is usually required to be not greater than 0.5 ohm. In some examples, a diameter of an enamelled copper wire is 0.25 mm, and a cross-sectional area of the enamelled copper wire is 0.049 mm². A line width of the charging coil 120 printed by using nano-silver paste is 0.3 mm. In this case, a thickness of the nano-silver paste is 0.16 mm, which is equivalent to the cross-sectional area of the copper wire and resistance of coils formed by winding the copper wire.

When a material of the printed coil is conductive ceramic, the conductive ceramic is used as the printed coil and is two-color molded with the ceramic bottom housing 110. In addition, the printed coil is insulated from the ceramic bottom housing 110 to ensure normal use of the charging coil 120. A coil gap of the charging coil 120 may be filled with a part of the ceramic bottom housing 110, and the part of the ceramic bottom housing 110 is used as an insulation layer, to implement insulation between the conductive ceramic and the ceramic bottom housing 110. It may be understood that the conductive ceramic and the ceramic bottom housing 110 may form an integrated structure through sintering.

Two-color molding is also called two-shot injection molding. Two plastics or two ceramic materials are injected on an injection machine.

In some possible implementations, the protective film 140 may be a metal film, or the protective film 140 may be a non-metal film made of plastic or fiber.

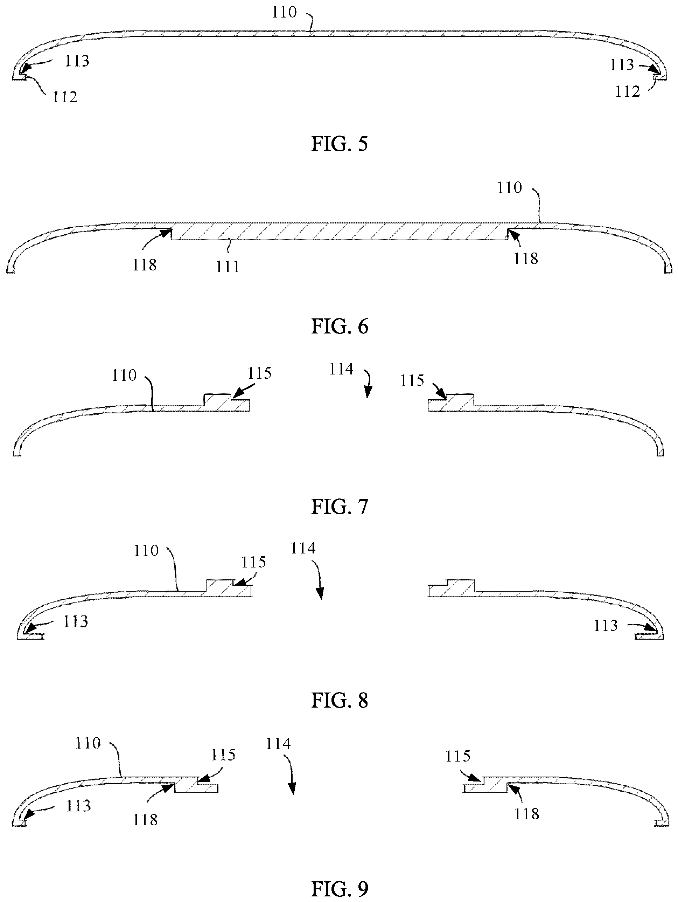

FIG. 5 is a sectional view of another ceramic bottom housing 110 according to an embodiment of this application.

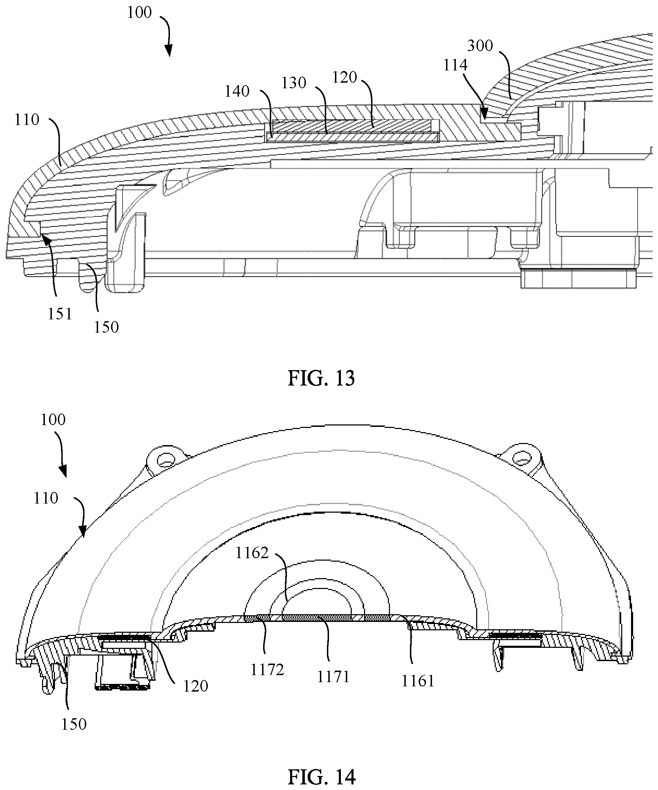

Refer to FIG. 5. In some possible implementations, a clamping portion 112 is extendedly disposed at an edge of an inner side surface of the ceramic bottom housing 110, and the clamping portion 112 is configured to clamp to a mating portion 151 (for example, as shown in FIG. 13 in the following content) disposed on a plastic inner housing 150, to increase a bonding force between the ceramic bottom housing 110 and the plastic inner housing 150.

Still refer to FIG. 5. The clamping portion 112 and the inner side surface of the ceramic bottom housing 110 jointly define a first stepped surface 113, and the first stepped surface 113 is configured to fit with the plastic inner housing 150. This helps increase the bonding force between the plastic inner housing 150 and the ceramic bottom housing 110.

A specific structure of the clamping portion 112 is not limited herein. For example, the clamping portion 112 is of a ring structure. Correspondingly, the mating portion 151 may be a clamping groove surrounding the plastic inner housing 150, and the clamping portion 112 is inserted into the clamping groove (for example, as shown in FIG. 13 in the following content). Alternatively, a plurality of clamping portions 112 circumferentially distributed around an axial direction of the ceramic bottom housing 110 are disposed at the bottom of the ceramic bottom housing 110. Correspondingly, a plurality of mating portions 151 are disposed on a side wall of the plastic inner housing 150, and the plurality of mating portions 151 are in a one-to-one correspondence with the plurality of clamping portions 112. In addition, all of the plurality of mating portions 151 may be clamping grooves into which the clamping portions 112 are inserted.

A longitudinal section of the clamping portion 112 may be a semicircle, a semi-ellipse, or a polygon. For example, in this embodiment of this application, the longitudinal section of the clamping portion 112 is a rectangle. The longitudinal section of the clamping portion 112 is parallel to the axial direction of the ceramic bottom housing 110.

FIG. 6 is a sectional view of still another ceramic bottom housing 110 according to an embodiment of this application.

Refer to FIG. 6. In some examples, a protruding portion 111 is extendedly disposed in the middle of an inner side surface of the ceramic bottom housing 110, the protruding portion 111 and the inner side surface of the ceramic bottom housing 110 jointly define a second stepped surface 118, and the second stepped surface 118 is disposed close to a charging coil 120 that is disposed on the inner side surface of the ceramic bottom housing 110. The second stepped surface 118 is disposed, so that a position of the charging coil 120 on the inner side surface of the ceramic bottom housing 110 can be positioned, and a contact area between the ceramic bottom housing 110 and a plastic inner housing 150 can be increased, which helps increase a bonding force between the ceramic bottom housing 110 and the plastic inner housing 150. In addition, in a nano injection molding process, the charging coil 120 may be prevented from being damaged because the charging coil 120 is impacted by plastic injection molding.

A specific structure and shape of the protruding portion 111 are not limited herein. For example, the protruding portion 111 may be of a structure like a ring structure or a circular structure, and even the protruding portion 111 may include a plurality of protruding segments spaced along a circumferential direction of the ceramic bottom housing 110.

It may be understood that there may be a gap between a side wall of the charging coil 120 and a side wall of the protruding portion 111, or the side wall of the charging coil 120 contacts the side wall of the protruding portion 111. This is not specifically limited herein.

FIG. 7 is a sectional view of a ceramic bottom housing 110 according to an embodiment of this application.

Refer to FIG. 7. In some possible implementations, a mounting through hole 114 that penetrates the ceramic bottom housing 110 is disposed in the middle of the ceramic bottom housing 110, and a third stepped surface 115 that is configured to fit with a transparent cover plate 300 is defined on an inner wall of the mounting through hole 114, to meet a use requirement of the wearable device 1000. The third stepped surface 115 may be configured to position relative positions of the transparent cover plate 300 and the ceramic bottom housing 110, and may provide a position for mounting the transparent cover plate 300.

Still refer to FIG. 7. Along a thickness direction of the ceramic bottom housing 110, the mounting through hole 114 may include a first hole segment and a second hole segment that are disposed coaxially, where a hole diameter of the first hole segment is greater than a hole diameter of the second hole segment, the first hole segment and the second hole segment jointly define the third stepped surface 115, the first hole segment is close to an outer side surface of the ceramic bottom housing 110, and the second hole segment is close to an inner side surface of the ceramic bottom housing 110.

The transparent cover plate 300 may be made of a transparent material like glass or sapphire. In addition, the transparent cover plate 300 may be securely connected to the ceramic bottom housing 110 in a bonding manner.

It should be noted that, in embodiments, the first stepped surface 113, the second stepped surface 118, and the third stepped surface 115 are all obtained through machining (CNC machining, namely, machining by using a machine tool). Therefore, the ceramic bottom housing 110 in embodiments may have at least one of the first stepped surface 113, the second stepped surface 118, and the third stepped surface 115. FIG. 8 is a sectional view of another ceramic bottom housing according to an embodiment of this application; and FIG. 9 is a sectional view of still another ceramic bottom housing according to an embodiment of this application. For example, as shown in FIG. 8, a first stepped surface 113 and a third stepped surface 115 are disposed on the ceramic bottom housing 110. Alternatively, as shown in FIG. 9, a first stepped surface 113, a second stepped surface 118, and a third stepped surface 115 are disposed on the ceramic bottom housing 110.

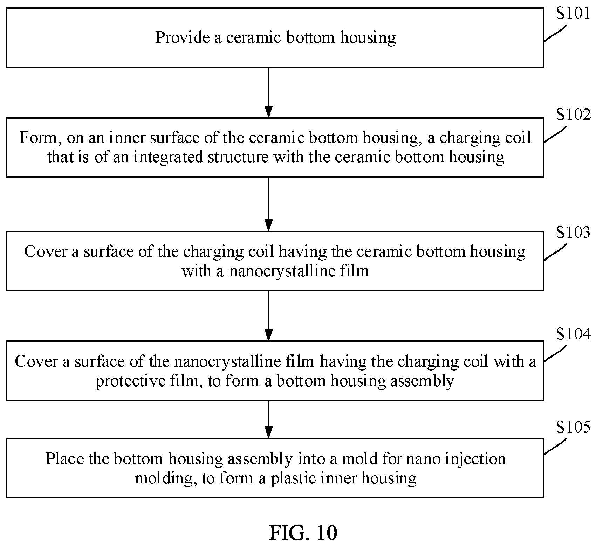

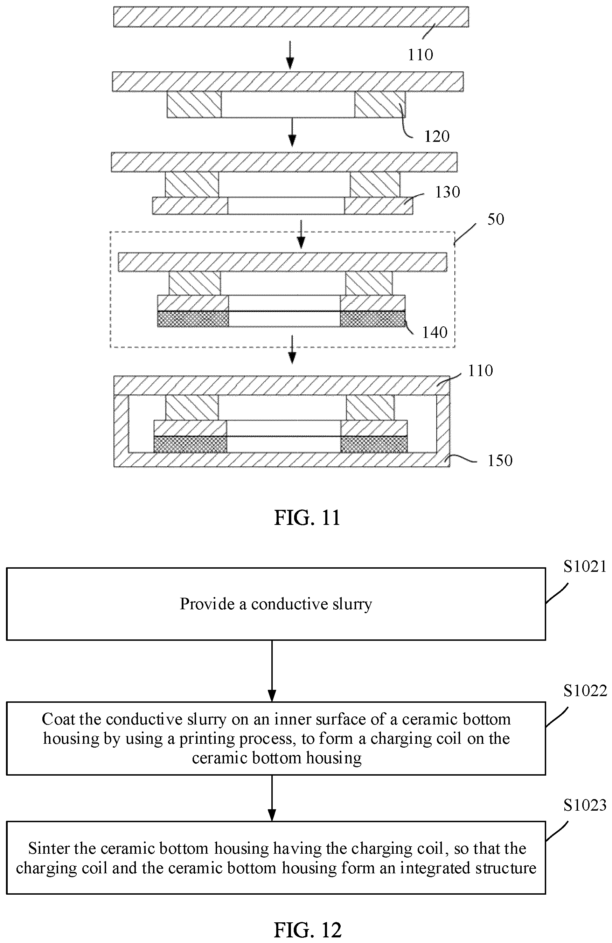

FIG. 10 is a flowchart of a method for preparing a housing 100 according to an embodiment of this application; and FIG. 11 is a diagram of a preparation process of the preparation method shown in FIG. 10. Refer to FIG. 10 and FIG. 11. In a preparation process of the preparation method, a nanocrystalline film 130 is first mounted on a charging coil 120, and then a protective film 140 is mounted on the nanocrystalline film 130. Certainly, the nanocrystalline film 130 and the protective film 140 may alternatively be assembled in advance to form a film assembly, and then the film assembly is assembled with the charging coil 120. Therefore, step S103 and step S104 may be combined into one step.

The following describes in detail steps of the preparation method shown in FIG. 10.

S101: Provide a ceramic bottom housing 110.

A specific shape of the ceramic bottom housing 110 may be designed based on a size required by a wearable device 1000. In addition, the ceramic bottom housing 110 may be set as a planar surface or an arc surface based on a type of the wearable device 1000. A material of the ceramic bottom housing 110 may be a non-conductive and non-transparent ceramic material, and may be determined based on a use requirement. For example, a zirconia ceramic material may be used.

A manner of forming the ceramic bottom housing 110 may be as follows: Dry pressing is performed on ceramic powder, to form, through sintering, a ceramic matrix 510 that is of a plate structure, and then machining is performed on the ceramic matrix 510 to form the ceramic bottom housing 110. Alternatively, a ceramic injection molding process may be used to form a ceramic matrix 510 that is of a plate structure, and then machining is performed on the ceramic matrix 510 to form the ceramic bottom housing 110. Certainly, the manner of forming the ceramic bottom housing 110 is not limited to the two types.

An objective of machining is to form a structural feature of the ceramic bottom housing 110. For example, the structural feature includes at least one of a first stepped surface 113, a second stepped surface 118, and a third stepped surface 115. Certainly, the structural feature of the ceramic bottom housing 110 is not limited to features such as the first stepped surface 113, the second stepped surface 118, and the third stepped surface 115. For example, machining (for example, CNC machining) is performed on the ceramic matrix 510 that is of a plate structure to form the ceramic bottom housing 110 shown in FIG. 5 in the foregoing content. Alternatively, machining is performed on the ceramic matrix 510 that is of a plate structure to form the ceramic bottom housing 110 shown in FIG. 8 in the foregoing content. Alternatively, machining is performed on the ceramic matrix 510 that is of a plate structure to form the ceramic bottom housing 110 shown in FIG. 9 in the foregoing content.

S102: Form, on an inner surface of the ceramic bottom housing 110, a charging coil 120 that is of an integrated structure with the ceramic bottom housing 110.

A shape of the charging coil 120 may be determined based on a shape of the inner surface of the ceramic bottom housing 110. For example, for the ceramic bottom housing 110 shown in FIG. 5 in the foregoing content, a shape of the charging coil 120 may be a circle.

Because the charging coil 120 is a printed coil, after the charging coil 120 is formed on a predetermined position of the ceramic bottom housing 110 by using a printing process,
the charging coil 120 and the ceramic bottom housing 110 may be sintered based on a predetermined temperature and predetermined time, so that the ceramic bottom housing 110 and the charging coil 120 form an integrated structure. The predetermined temperature and the predetermined time may be determined based on materials of the ceramic bottom housing 110 and the charging coil 120, and are not specifically limited herein.

FIG. 12 is a flowchart of a method for preparing a printed coil according to an embodiment of this application. The following describes in detail the preparation method shown in FIG. 12.

S1021: Provide a conductive slurry.

Specifically, the conductive slurry is a liquid slurry capable of conducting electricity. For example, the conductive slurry may be a conductive material like nano-silver paste or conductive ceramic.

S1022: Coat the conductive slurry on an inner surface of a ceramic bottom housing 110 by using a printing process, to form a charging coil 120 on the ceramic bottom housing 110.

Specifically, a printed circuit coil of a predetermined shape is printed on the ceramic bottom housing 110 by using a printing device, to form the charging coil 120 on the inner surface of the ceramic bottom housing 110.

S1023: Sinter the ceramic bottom housing 110 having the charging coil 120, so that the charging coil 120 and the ceramic bottom housing 110 form an integrated structure.

Specifically, a temperature and time during sintering may be determined based on materials of the ceramic bottom housing 110 and the charging coil 120, and are not specifically limited herein. For example, sintering is performed for 4 hours at 140°C, so that the ceramic bottom housing 110 and the charging coil 120 form the integrated structure.

S103: Cover a surface of the charging coil 120 having the ceramic bottom housing 110 with a nanocrystalline film 130.

A shape and a thickness of the nanocrystalline film 130 may be determined based on use, and are not specifically limited herein. For example, in some examples, a shape of the nanocrystalline film 130 is a circular ring, an outer diameter of the nanocrystalline film 130 is greater than an outer diameter of the charging coil 120, and an inner diameter of the nanocrystalline film 130 is greater than an inner diameter of the charging coil 120. This helps prevent a plastic inner housing 150 from impacting the charging coil 120.

The nanocrystalline film 130 may be securely connected to the charging coil 120 in a bonding manner. For example, glue may be coated on the nanocrystalline film 130, so that the nanocrystalline film 130 may be pasted on the charging coil 120.

S104: Cover a surface of the nanocrystalline film 130 having the charging coil 120 with a protective film 140, to form a bottom housing assembly 50.

Still refer to FIG. 11. The bottom housing assembly 50 may include the ceramic bottom housing 110, the charging coil 120, the nanocrystalline film 130, and the protective film 140. A shape of the protective film 140 may be the same as the shape of the nanocrystalline film 130. Therefore, the shape of the protective film 140 may be a circular ring, an inner diameter of the protective film 140 is equal to the inner diameter of the nanocrystalline film 130, and an outer diameter of the protective film 140 is equal to the outer diameter of the nanocrystalline film 130. The protective film 140 may be a metal film or a non-metal film. For example, in some examples, the protective film 140 is plastic or fiber. The protective film 140 may be securely connected to the nanocrystalline film 130 in a bonding manner. For example, glue may be coated on the nanocrystalline film 130 and/or the protective film 140, so that the nanocrystalline film 130 may be bonded to the protective film 140.

S105: Place the bottom housing assembly 50 having the protective film 140 into a mold for nano injection molding, to form the plastic inner housing 150 that is of an integrated structure with the protective film 140 and the ceramic bottom housing 110.

After the bottom housing assembly 50 is placed into the mold, an outer surface of the ceramic bottom housing 110 of the bottom housing assembly 50 is in contact with the mold. In the nano injection molding process, a plastic liquid impacts the ceramic bottom housing 110 and the protective film 140 along a thickness direction of the bottom housing assembly 50. Because of the protective film 140, the nanocrystalline film 130 is not damaged by the plastic liquid, and the plastic inner housing 150 that is of an integrated structure with the ceramic bottom housing 110 and the protective film 140 is formed after nano injection molding.

A specific shape of the plastic inner housing 150 may be determined based on a type of the wearable device 1000 and an internal layout, and is not specifically limited herein. In addition, a material of the plastic inner housing 150 may be determined based on a use requirement, and is not specifically limited herein.

Nano injection molding refers to a nano molding technology (NMT, Nano Molding Technology), which is a technology in which a metal surface is first nano-processed, and plastic is directly injected and molded on the metal surface to obtain a plastic+metal integrated structure. In this embodiment of this application, nano injection molding is used, so that the plastic inner housing 150 can be directly molded on the bottom housing assembly 50 and form an integrated structure with the bottom housing assembly 50.

In this embodiment, the printed coil is used as the charging coil 120 and is co-sintered with the ceramic bottom housing 110 to form an integrated structure. In addition, the protective film 140 is disposed, and nano injection molding may be performed on a surface of the protective film 140 to form the plastic inner housing 150 that is of an integrated structure with the ceramic bottom housing 110 and the protective film 140. In this way, a thickness of the housing 100 can be reduced, and a bonding force between the ceramic bottom housing 110 and the plastic inner housing 150 can be increased.

The following describes another housing 100 provided in an embodiment of this application and a method for preparing the housing 100.

FIG. 13 is a partial sectional view of another housing 100 according to an embodiment of this application.

Refer to FIG. 13. This embodiment of this application provides another housing 100. The housing 100 includes at least a ceramic bottom housing 110, a charging coil 120, a nanocrystalline film 130, a protective film 140, and a plastic inner housing 150. A same part of the housing 100 shown in FIG. 13 and the housing 100 shown in FIG. 3 is not described herein again. A difference between the housing 100 shown in FIG. 13 and the housing 100 shown in FIG. 3 lies in that: structures of the ceramic bottom housings 110 are different, structures of the plastic inner housings 150 are different, and the ceramic bottom housing 110 in this embodiment is a ceramic bottom housing 110 formed through hot bending of a ceramic piece 600. Hot bending molding means first heating the ceramic piece 600, and then bending the ceramic piece 600, so that a shape of the ceramic piece 600 changes to a predetermined shape.

The ceramic bottom housing 110 is manufactured by using a hot bending molding process. In this case, a thickness of the ceramic piece 600 may be reduced, so that a thickness of the ceramic bottom housing 110 may be reduced, and a thickness of the housing 100 may be further reduced. Therefore, by using a hot bending process, the thickness of the ceramic piece 600 may be reduced, and the thickness of the ceramic bottom housing 110 may be reduced. It should be noted that, the thickness of the ceramic bottom housing 110 is a value of a spacing between a top surface of the ceramic bottom housing 110 and a bottom surface of the ceramic bottom housing 110.

A material, a structure, and a shape of the charging coil 120 are described in detail in the foregoing content, and details are not described herein again. In addition, it should be emphasized that in this embodiment, the charging coil 120 is fastened to an inner side surface of the ceramic bottom housing 110.

In this embodiment, the charging coil 120 may be a printed coil or a conductive coil formed by winding a metal wire. The conductive coil may also be referred to as an enamelled conductive coil, that is, the charging coil 120 is formed by winding an enamelled wire. In other words, the metal wire may be referred to as an enamelled wire. For example, in some examples, the metal wire is a copper wire. In addition, the conductive coil may be fastened to an inner surface of the ceramic bottom housing 110 in a bonding manner. Certainly, a manner of fastening the conductive coil to the ceramic bottom housing 110 is not limited to bonding.

It should be noted that, when the charging coil 120 is a printed coil, the printed coil and the ceramic bottom housing 110 may be sintered into an integrated structure, or the printed coil and the ceramic bottom housing 110 are securely connected but are not of an integrated structure.

Structures and fitting relationships of the nanocrystalline film 130, the protective film 140, and the plastic inner housing 150 are all described in detail in the foregoing content, and are not described in detail herein again.

It should be noted that the housing 100 in FIG. 13 has the nanocrystalline film 130 and the protective film 140. However, the nanocrystalline film 130 and the protective film 140 may also be removed from the housing 100 in this embodiment. In this case, the plastic inner housing 150 covers a surface of the charging coil 120 and contacts the inner side surface of the ceramic bottom housing 110, and the plastic inner housing 150 is securely connected to the ceramic bottom housing 110. In addition, the plastic inner housing 150 may be securely connected to the ceramic bottom housing 110 in a bonding manner. Certainly, a manner of connecting the plastic inner housing 150 and the ceramic bottom housing 110 is not limited to bonding. For example, the plastic inner housing 150 may also be of an integrated structure with the ceramic bottom housing 110. The plastic inner housing 150 is securely connected to the ceramic bottom housing 110, so that the charging coil 120 can be clamped tightly. This helps further improve firmness of a connection between the charging coil 120 and the ceramic bottom housing 110.

In this embodiment, a structure of the ceramic bottom housing 110 formed through hot bending may be the same as that of the ceramic bottom housing 110 shown in any one of FIG. 5 to FIG. 9 in the foregoing content. Therefore, the ceramic bottom housing 110 formed through hot bending has at least one of a first stepped surface 113, a second stepped surface 118, and a third stepped surface 115. For example, as shown in FIG. 13, a first stepped surface 113, a second stepped surface 118, and a third stepped surface 115 are disposed on the ceramic bottom housing 110. Certainly, the structure of the ceramic bottom housing 110 formed through hot bending may alternatively be the same as the structure of the ceramic bottom housing 110 in FIG. 3. In other words, the first stepped surface 113, the second stepped surface 118, and the third stepped surface 115 may not be disposed on the ceramic bottom housing 110 formed through hot bending.

To meet a light transmission requirement of the wearable device 1000, a mounting through hole 114 is disposed in the middle of the ceramic bottom housing 110, and the third stepped surface 115 is defined on an inner wall of the mounting through hole 114, so that a transparent cover plate 300 can be mounted on the ceramic bottom housing 110. However, in addition to a manner of disposing the mounting through hole 114 on the ceramic bottom housing 110 to mount the transparent cover plate 300300, that is, the ceramic bottom housing 110 and the transparent cover plate 300 are of a split structure, the transparent cover plate 300 and the ceramic bottom housing 110 may be of an integrated structure.

The following describes a structure of a ceramic bottom housing 110 that does not have a mounting through hole 114 but can meet a light transmission requirement of the wearable device 1000.

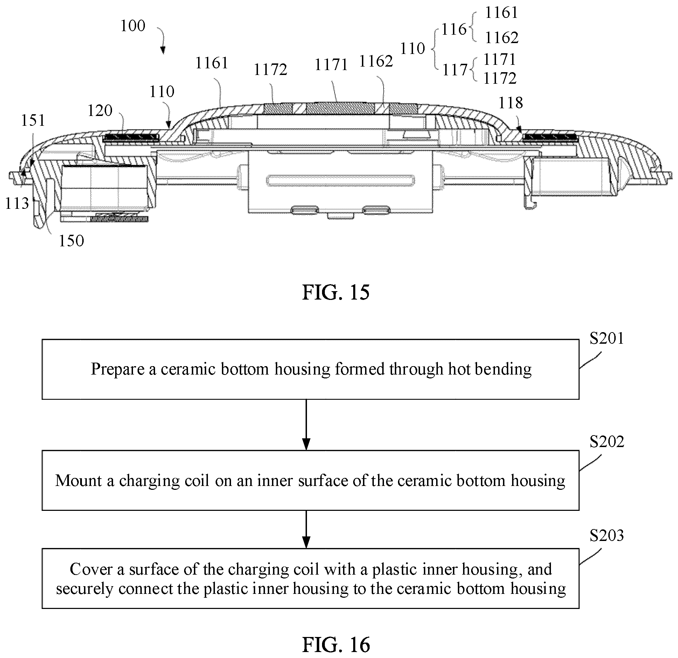

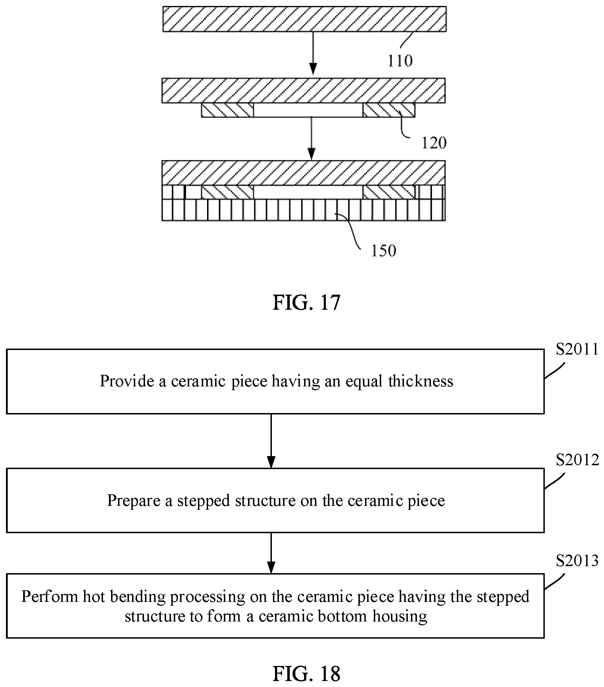

FIG. 14 is a partial three-dimensional diagram of still another housing 100 according to an embodiment of this application; and FIG. 15 is a front view of the housing shown in FIG. 14. Refer to FIG. 14 and FIG. 15. A ceramic bottom housing 110 may include a connecting portion 116 and a transparent portion 117. Refer to FIG. 18. A charging coil 120 is mounted on an inner side surface of the connecting portion 116. A material of the connecting portion 116 is a non-transparent ceramic material, and the transparent portion 117 is transparent ceramic and is sintered with the connecting portion 116 into an integrated structure. In this way, a complete two-color integrated ceramic bottom housing 110 can be formed, and costs of the ceramic bottom housing 110 can be reduced. Two-color integration is two-shot integration molding, which is the same as the two-color molding in the foregoing content.

Compared with implementing light transmission by using a transparent cover plate 300, transparent ceramic is used in a region that needs to transmit light and that is of the ceramic bottom housing 110, and the transparent ceramic and opaque ceramic are co-sintered to form the ceramic bottom housing 110 of an integrated structure, so that a seamless structure can be implemented, and aesthetics of the ceramic bottom housing 110 can be improved. Because the transparent ceramic is used in the region that needs to transmit light and that is of the ceramic bottom housing 110, the transparent cover plate 300 may be removed. Therefore, assembly steps of the housing 100 can be simplified, and costs of the housing 100 can be reduced. In addition, because the connecting portion 116 and the transparent portion 117 are of an integrated structure, a bonding force between the connecting portion 116 and the transparent portion 117 is high, and the transparent portion 117 is not prone to be detached from the connecting portion 116.

It should be noted that materials of the transparent portion 117 and the connecting portion 116 may be determined based on a use requirement, and are not specifically limited herein. In addition, the connecting portion 116 may be a planar surface or an arc surface, and the transparent portion 117 may also be a plane surface or an arc surface.

A specific shape of the transparent portion 117 may be determined based on a light transmission requirement, and is not specifically limited herein. For example, refer to FIG. 14 and FIG. 15. In some examples, the transparent portion 117 includes a first transparent portion 1171 and an annular second transparent portion 1172, the first transparent portion 1171 is located in the second transparent portion 1172, and an annular gap for accommodating a part of the connecting portion 116 is defined between the first transparent portion 1171 and the second transparent portion 1172. The connecting portion 116 includes a first connecting portion 1161 having a through hole in the middle and a second connecting portion 1162 that is of an annular structure. The first transparent portion 1171 is located in the second connecting portion 1162. The second connecting portion 1162 is located in the first transparent portion 1171 and the second transparent portion 1172. The second transparent portion 1172 is located in the through hole of the first connecting portion 1161 and is securely connected to the first connecting portion 1161.

It should be noted that, the ceramic bottom housing 110 jointly formed by the connecting portion 116 and the transparent portion 117 may also have at least one of a first stepped surface 113 and a second stepped surface 118 as the ceramic bottom housings 110 shown in FIG. 5 and FIG. 6. For example, at least one of the first stepped surface 113 and the second stepped surface 118 may be disposed on an inner side surface of the connecting portion 116. This is not specifically limited herein. For example, refer to FIG. 15. The first stepped surface 113 and the second stepped surface 118 are disposed on an inner side surface of the first connecting portion 1161. Certainly, the first stepped surface 113 and the second stepped surface 118 may not be disposed on the ceramic bottom housing 110 formed by the connecting portion 116 and the transparent portion 117.

In conclusion, because the ceramic bottom housing 110 in this embodiment is formed through hot bending, a thinner ceramic piece 600 may be used for forming the ceramic bottom housing 110. Therefore, because the thinner ceramic piece 600 is used for forming the ceramic bottom housing 110, a thickness of the ceramic bottom housing 110 may be reduced, so that a thickness of the housing 100 can be reduced. In addition, because the housing 100 in this embodiment may further use a printed coil as the charging coil 120, and/or nano injection molding may be performed on the protective film 140 to form the plastic inner housing 150 that is of an integrated structure with the protective film 140 and the ceramic bottom housing 110, the thickness of the housing 100 can be further reduced. In addition, the ceramic bottom housing 110 in this embodiment may be made of transparent ceramic and non-transparent ceramic. This can improve aesthetics of the ceramic bottom housing 110.

FIG. 16 is a flowchart of a method for preparing another housing 100 according to an embodiment of this application; and FIG. 17 is a diagram of a preparation process of the preparation method shown in FIG. 16. Refer to FIG. 16 and FIG. 17. A ceramic bottom housing 110 formed through hot bending may be assembled with a charging coil 120 and a plastic inner housing 150.

The following describes in detail steps of the preparation method shown in FIG. 16.

S201: Prepare the ceramic bottom housing 110 formed through hot bending.

After hot bending processing is performed on a ceramic piece 600 having a stepped structure, a planar stepped surface structure of the ceramic piece 600 becomes a three-dimensional stepped structure. This can save a large amount of machining time and help improve production efficiency of the ceramic bottom housing 110 compared with processing a stepless dimension blank into a three-dimensional stepped structure by machining in the conventional technology. In addition, because the hot bending processing is performed on the ceramic piece 600, a thickness of the ceramic bottom housing 110 can be reduced. In addition, strength of the ceramic bottom housing 110 that is formed by performing the hot bending processing on the ceramic piece 600 can also meet a use requirement.

Because the ceramic bottom housing 110 has a stepped structure, a method for preparing the ceramic bottom housing 110 may include the following manners: FIG. 18 is a flowchart of a preparation method for preparing a ceramic bottom housing 110 formed through hot bending according to an embodiment of this application. Refer to FIG. 18. A first method for preparing a ceramic bottom housing 110 formed through hot bending includes the following steps: S2011: Provide a ceramic piece 600 having an equal thickness. S2012: Prepare a stepped structure on the ceramic piece 600. S2013: Perform hot bending processing on the ceramic piece 600 having the stepped structure to form the ceramic bottom housing 110. Alternatively, a second method for preparing the ceramic bottom housing 110 formed through hot bending is as follows: First, a ceramic piece 600 having a stepped structure and an equal thickness is obtained by using a ceramic injection molding process. Then, hot bending processing is performed on the ceramic piece 600 having the stepped structure and the equal thickness, to form the ceramic bottom housing 110. Certainly, a forming process for preparing the ceramic bottom housing 110 formed through hot bending is not limited to the foregoing two methods.

The following describes in detail the preparation method shown in FIG. 18.

S2011: Provide a ceramic piece 600 having an equal thickness.

Specifically, the ceramic piece 600 is of a plate structure, and a thickness of the ceramic piece 600 may be determined based on a thickness of the ceramic bottom housing 110. For example, a thickness of the ceramic piece 600 may be within 0.4 cm. In addition, a ceramic piece 600 of a corresponding type may be selected based on whether a third stepped surface 115 exists on the ceramic bottom housing 110.

When the ceramic bottom housing 110 has the third stepped surface 115, the ceramic piece 600 is an opaque ceramic material, and the ceramic piece 600 may be a thin sheet of an equal wall thickness obtained by using a ceramic tape casting process, an injection molding process, a gel process, a dry pressing process, or the like.

When the ceramic bottom housing 110 does not have the third stepped surface 115, because transparent ceramic is used in a region that needs to transmit light and that is of the ceramic bottom housing 110, a ceramic piece 600 having transparent ceramic and an equal wall thickness is used.

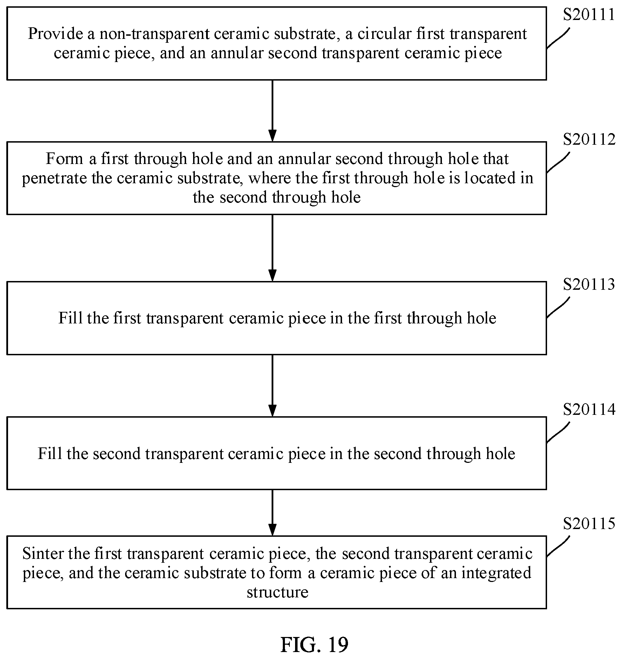

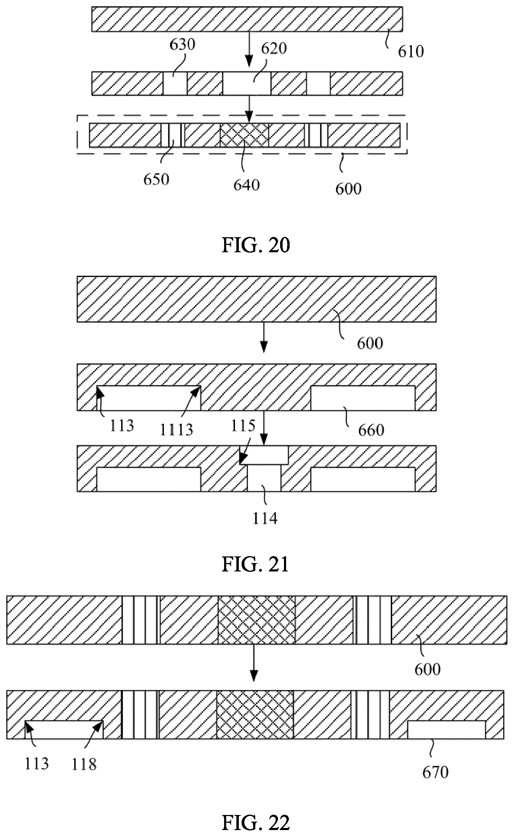

A method for preparing the ceramic piece 600 having the transparent ceramic and the equal wall thickness may be: sintering transparent ceramic and opaque ceramic to form a ceramic piece 600 having an integrated structure and an equal wall thickness. FIG. 19 is a flowchart of a preparation method for preparing a ceramic piece 600 having transparent ceramic according to an embodiment of this application; and FIG. 20 is a diagram of a preparation process of the preparation method shown in FIG. 19. Refer to FIG. 19 and FIG. 20. Preparing a ceramic piece 600 having transparent ceramic and an equal thickness includes the following steps:

S20111: Provide a non-transparent ceramic substrate 610, a circular first transparent ceramic piece 640, and an annular second transparent ceramic piece 650.

Specifically, a shape of the ceramic substrate 610 may be a circular polygonal plate structure, which may be determined based on a type of the wearable device 1000, and is not specifically limited herein. The transparent ceramic piece 600 means that the ceramic piece 600 can transmit light, to meet a light transmission requirement of the wearable device 1000. A shape of the first transparent ceramic piece 640 may be a circle, or may be a polygon, an ellipse, or the like. A specific shape of the second transparent ceramic piece 650 may be an elliptical, circular, or polygonal ring structure. For example, in this embodiment of this application, the second transparent ceramic piece 650 is a circular ring.

S20112: Form a first through hole 620 and an annular second through hole 630 that penetrate the ceramic substrate 610, where the first through hole 620 is located in the second through hole 630.

A shape of the first through hole 620 is the same as the shape of the first transparent ceramic piece 640, so that the ceramic substrate 610 and the first transparent ceramic piece 640 form an integrated structure after being sintered. Similarly, a shape of the second through hole 630 is the same as the shape of the second transparent ceramic piece 650, so that the ceramic substrate 610 and the second transparent ceramic piece 650 form an integrated structure after being sintered.

It should be noted that, the first through hole 620 may be formed before the second through hole 630; or the second through hole 630 is formed before the first through hole 620; or the first through hole 620 and the second through hole 630 may be simultaneously formed.

S20113: Fill the first transparent ceramic piece 640 in the first through hole 620.

S20114: Fill the second transparent ceramic piece 650 in the second through hole 630.

In this embodiment, step S20113 is performed before step S20114. It may be understood that step S20114 may be performed before step S20113, or step S20113 and step S20114 are simultaneously performed.

S20115: Sinter the first transparent ceramic piece 640, the second transparent ceramic piece 650, and the ceramic substrate 610 to form the ceramic piece 600 of an integrated structure.

A temperature and time for sintering the first transparent ceramic piece 640, the second transparent ceramic piece 650, and the ceramic substrate 610 may be determined based on materials of the first transparent ceramic piece 640, the second transparent ceramic piece 650, and the ceramic substrate 610, and are not specifically limited herein. In addition, after step S20115 is completed, step S2012 is performed.

S2012: Prepare a stepped structure on the ceramic piece 600.

Specifically, the stepped structure may include at least one of the following stepped surfaces: a first stepped surface 113, a second stepped surface 118, and the third stepped surface 115. Several types of stepped surfaces specifically included in the stepped structure may be determined based on a use requirement, and are not specifically limited herein. In some examples, FIG. 21 is a diagram of a process of preparing a stepped structure according to an embodiment of this application. Refer to FIG. 20. The stepped structure includes the first stepped surface 113, the second stepped surface 118, and the third stepped surface 115. In addition, a method for preparing the stepped structure shown in FIG. 21 may include the following steps.

Step A: Form a first annular groove 660 on a bottom surface of the ceramic piece 600, where the first stepped surface 113 and the second stepped surface 118 that are spaced along a radial direction are formed on an inner wall of the first annular groove 660, and the second stepped surface 118 is disposed close to an axis of the first annular groove 660. Step B: Form a mounting through hole 114 that penetrates the ceramic piece 600, where the mounting through hole 114 is located in the first annular groove 660 and is disposed close to the second stepped surface 118, and the third stepped surface 115 is defined on an inner wall of the mounting through hole 114.

In step A, a specific shape of the first annular groove 660 may be determined based on a shape of the ceramic bottom housing 110 and shapes of the first stepped surface 113 and the second stepped surface 118. For example, in some examples, the first annular groove 660 is an annular groove.

It should be noted that a sequence of step A and step B may be exchanged, that is, step B is performed before step A. Certainly, step A and step B may alternatively be simultaneously performed.

In some examples, when there is transparent ceramic on the ceramic piece 600, the stepped structure includes the first stepped surface 113 and the second stepped surface 118. Therefore, the method for preparing the stepped structure may include the following step: Step C: Form a second annular groove 670 on a bottom surface of the ceramic piece 600, where the first stepped surface 113 and the second stepped surface 118 that are spaced along a radial direction are formed on an inner wall of the second annular groove 670, and the second stepped surface 118 is disposed close to an axis of the second annular groove 670. FIG. 22 is a diagram of a process of preparing another stepped structure according to an embodiment of this application. Refer to FIG. 22. A ceramic piece 600 that does not have a third stepped surface 115 and has an equal thickness may be obtained. A specific shape of the second annular groove 670 may be determined based on the shape of the ceramic bottom housing 110 and the shapes of the first stepped surface 113 and the second stepped surface 118. For example, in some examples, the second annular groove 670 is an annular groove.

S2013: Perform hot bending processing on the ceramic piece 600 having the stepped structure to form the ceramic bottom housing 110.

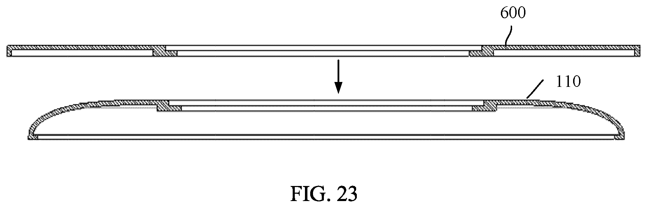

FIG. 23 is a preparation diagram of performing hot pressing processing on the ceramic piece 600 having the stepped structure according to an embodiment of this application. Refer to FIG. 23. A planar stepped structure of the ceramic piece 600 may be converted into a three-dimensional stepped structure through hot bending processing, to meet a use requirement. This greatly reduces machining time compared with machining a three-dimensional stepped structure in the conventional technology. In addition, a thin ceramic piece 600 may be used to reduce a thickness of the ceramic bottom housing 110.

S202: Mount the charging coil 120 on an inner surface of the ceramic bottom housing 110.

Different processing manners are selected based on the charging coil 120, to mount the charging coil 120 on the inner surface of the ceramic bottom housing 110. For example, when the charging coil 120 is a conductive coil, the charging coil 120 may be directly bonded to the inner surface of the ceramic bottom housing 110 in a bonding manner. Alternatively, when the charging coil 120 is a printed coil, the charging coil 120 may be formed on the inner surface of the ceramic bottom housing 110 by using a printing process. The printing coil may form an integrated structure with the ceramic bottom housing 110 by using a sintering process, or sintering is not performed.

For example, a preparation method for forming, on an inner side surface of the ceramic bottom housing 110 formed through hot bending, a printed coil that is of an integrated structure with the ceramic bottom housing 110 may be the preparation method described in FIG. 12 in the foregoing content. Details are not described herein again. It should be noted that, when the printed coil does not need to form an integrated structure with the ceramic bottom housing 110, step S1023 in FIG. 12 may be removed. In addition, after the charging coil 120 is formed on the ceramic bottom housing 110 by using a printing process, the charging coil 120 may be quickly cured on the inner side surface of the ceramic bottom housing 110 by using a drying process.

S203: Cover a surface of the charging coil 120 with the plastic inner housing 150, and securely connect the plastic inner housing 150 to the ceramic bottom housing 110.

Because the plastic inner housing 150 covers the charging coil 120, the plastic inner housing 150 has been manufactured before being assembled with the charging coil 120. In addition, the plastic inner housing 150 may be securely connected to the inner side surface of the ceramic bottom housing 110 in a bonding manner. Certainly, a manner of connecting the plastic inner housing 150 and the ceramic bottom housing 110 is not limited to bonding.

In this embodiment, to improve efficiency of the charging coil 120, a nanocrystalline film 130 may cover the surface of the charging coil 120. Therefore, before the plastic inner housing 150 is assembled with the charging coil 120 and the ceramic bottom housing 110, and after the nanocrystalline film 130 is mounted on the surface of the charging coil 120, step S203 is performed.

In this embodiment, to reduce a thickness of the plastic inner housing 150, after step S202 is completed, a protective film 140 may cover the surface of the charging coil 120, then the ceramic bottom housing 110 having the protective film 140 and the charging coil 120 is placed into a mold for nano injection molding, the plastic inner housing 150 is formed in an injection molding process, and the plastic inner housing 150, the protective film 140, and the ceramic bottom housing 110 form an integrated structure.

Certainly, the protective film 140 and the nanocrystalline film 130 may alternatively coexist. In this embodiment, a method for preparing a housing 100 having the protective film 140 and the nanocrystalline film 130 is as follows: Step S201 and step S202 in FIG. 16 are first performed, and after step S202 is completed, step S103, step S104, and step S105 in FIG. 10 are performed.

In descriptions of embodiments of this application, it should be noted that, unless otherwise clearly specified and limited, the terms "installation", "connecting", and "connection" should be understood in a broad sense. For example, the connection may be a fixed connection, may be an indirect connection through an intermediate medium, or may be an internal connection between two elements or an interaction relationship between two elements. Persons of ordinary skill in the art may understand specific meanings of the terms in embodiments of this application based on a specific case.

In embodiments of this application, it is not implied that a described apparatus or element needs to have a particular orientation or be configured and operated in a particular orientation. Therefore, this cannot be understood as a limitation on embodiments of this application. In the descriptions of embodiments of this application, unless otherwise exactly and specifically ruled, "a plurality of" means two or more than two.

In the specification, claims, and accompanying drawings of embodiments of this application, the terms "first", "second", "third", "fourth", and the like (if existent) are intended to distinguish between similar objects but do not necessarily indicate a specific order or sequence. It may be understood that the data used in such a way is interchangeable in proper circumstances, so that embodiments of this application described herein can be implemented in other sequences than the sequence illustrated or described herein. In addition, the terms "include" and "have" and any other variants are intended to cover the non-exclusive inclusion. For example, a process, method, system, product, or device that includes a list of steps or units is not necessarily limited to those expressly listed steps or units, but may include other steps or units not expressly listed or inherent to such a process, method, product, or device.

The term "a plurality of" in this specification refers to two or more. The term "and/or" in this specification describes only an association relationship between associated objects and represents that three relationships may exist. For example, A and/or B may represent the following three cases: Only A exists, both A and B exist, and only B exists. In addition, a character "/" in this specification usually indicates an "or" relationship between associated objects, and a character "/" in a formula usually indicates a "divisible" relationship between associated objects.

It may be understood that various numbers in embodiments of this application are merely used for differentiation for ease of description, and are not used to limit the scope of embodiments of this application.

It should be understood that sequence numbers of the foregoing processes do not mean execution sequences in embodiments of this application. The execution sequences of the processes should be determined based on functions and internal logic of the processes, and should not be construed as any limitation on the implementation processes of embodiments of this application.

## Claims

1. A housing, comprising at least a ceramic bottom housing, a charging coil, a plastic inner housing, a nanocrystalline film, and a protective film, wherein
the charging coil is disposed on an inner side of the ceramic bottom housing, and the charging coil is a printed coil and is sintered with the ceramic bottom housing into an integrated structure;
the nanocrystalline film covers a surface of the charging coil and is securely connected to the charging coil;
the protective film covers a surface of the nanocrystalline film and is securely connected to the nanocrystalline film, and the protective film is configured to prevent the nanocrystalline film from being damaged in a process of forming the plastic inner housing through injection molding; and
the plastic inner housing is formed on an inner side surface of the ceramic bottom housing through nano injection molding and covers the protective film, so that the plastic inner housing, the ceramic bottom housing, and the protective film are of an integrated structure.

2. The housing according to claim 1, wherein the ceramic bottom housing is a ceramic bottom housing formed through hot bending of a ceramic piece.

3. The housing according to claim 1 or 2, wherein a mating portion is disposed on the plastic inner housing, a clamping portion is extendedly disposed at an edge of the inner side surface of the ceramic bottom housing, the clamping portion is clamped to the mating portion, and the charging coil is disposed on the inner side surface of the ceramic bottom housing.

4. The housing according to claim 3, wherein the clamping portion and the inner side surface of the ceramic bottom housing jointly define a first stepped surface, and the mating portion is a clamping groove for inserting the clamping portion.

5. The housing according to any one of claims 1 to 4, wherein a protruding portion is extendedly disposed in the middle of the inner side surface of the ceramic bottom housing, and the protruding portion and the inner side surface of the ceramic bottom housing jointly define a second stepped surface; and
the charging coil is disposed on the inner side surface of the ceramic bottom housing and is disposed close to the second stepped surface.

6. The housing according to any one of claims 1 to 5, wherein the housing further comprises a transparent cover plate, a mounting through hole that penetrates the ceramic bottom housing is disposed in the middle of the ceramic bottom housing, a third stepped surface is defined on an inner wall of the mounting through hole, and the transparent cover plate is mounted on the third stepped surface.

7. The housing according to any one of claims 1 to 5, wherein the ceramic bottom housing comprises a connecting portion and a transparent portion; and
a material of the connecting portion is a non-transparent ceramic material, and the transparent portion is transparent ceramic and is sintered with the connecting portion into an integrated structure.

8. The housing according to claim 7, wherein the transparent portion comprises a first transparent portion and an annular second transparent portion; and
the first transparent portion is located in the second transparent portion, and the first transparent portion and the second transparent portion jointly define an annular gap for accommodating a part of the connecting portion.

9. The housing according to any one of claims 1 to 8, wherein a material of the printed coil is nano-silver paste or conductive ceramic; and
when the material of the printed coil is the conductive ceramic, the printed coil is insulated from the ceramic bottom housing and is sintered with the ceramic bottom housing into an integrated structure.

10. The housing according to claim 9, wherein the protective film is a metal film, or the protective film is a non-metal film made of plastic or fiber.

11. A wearable device, comprising a conductive member and the housing according to any one of claims 1 to 10, wherein a charging coil of the housing is electrically connected to a host circuit of the wearable device via the conductive member.

12. A method for preparing a housing, comprising:
forming, on an inner surface of a ceramic bottom housing, a charging coil that is of an integrated structure with the ceramic bottom housing;
covering a surface of the charging coil with a nanocrystalline film;
covering a surface of the nanocrystalline film with a protective film, to form a bottom housing assembly; and
placing the bottom housing assembly having the protective film into a mold for nano injection molding, to form a plastic inner housing that is of an integrated structure with the protective film and the ceramic bottom housing.

13. The preparation method according to claim 12, wherein the forming, on an inner surface of a ceramic bottom housing, a charging coil that is of an integrated structure with the ceramic bottom housing comprises:
providing a conductive slurry;
coating the conductive slurry on the inner surface of the ceramic bottom housing by using a printing process, to form the charging coil on the ceramic bottom housing; and
sintering the ceramic bottom housing having the charging coil, so that the charging coil and the ceramic bottom housing form an integrated structure.

14. The preparation method according to claim 13, wherein the conductive slurry is nano-silver paste or conductive ceramic.

15. The preparation method according to claim 13 or 14, wherein the printing process comprises any one of the following processes: a screen printing process, a pad printing process, a 3D printing process, a sticker printing process, and a yellow light developing process.

16. The preparation method according to any one of claims 12 to 15, wherein before the forming, on an inner surface of a ceramic bottom housing, a charging coil that is of an integrated structure with the ceramic bottom housing, the method further comprises:
preparing the ceramic bottom housing formed through hot bending.

17. The preparation method according to claim 16, wherein the preparing the ceramic bottom housing formed through hot bending comprises:
providing a ceramic piece having an equal thickness;
preparing a stepped structure on the ceramic piece; and
performing hot bending processing on the ceramic piece having the stepped structure to form the ceramic bottom housing.

18. The preparation method according to claim 17, wherein the preparing a stepped structure on the ceramic piece comprises:
forming a first annular groove on a bottom surface of the ceramic piece, wherein a first stepped surface and a second stepped surface that are spaced along a radial direction are formed on an inner wall of the first annular groove, and the second stepped surface is disposed close to an axis of the first annular groove; and
forming a mounting through hole that penetrates the ceramic piece, wherein the mounting through hole is located in the first annular groove and is disposed close to the second stepped surface, and a third stepped surface is defined on an inner wall of the mounting through hole.

19. The preparation method according to claim 17, wherein the preparing a stepped structure on the ceramic piece comprises:
forming a second annular groove on a bottom surface of the ceramic piece, wherein a first stepped surface and a second stepped surface that are spaced along a radial direction are formed on an inner wall of the second annular groove, and the second stepped surface is disposed close to an axis of the second annular groove.

20. The preparation method according to claim 17, wherein the providing a ceramic piece having an equal thickness comprises:
providing a non-transparent ceramic substrate, a circular first transparent ceramic piece, and an annular second transparent ceramic piece;
forming a first through hole and an annular second through hole that penetrate the ceramic substrate, wherein the first through hole is located in the second through hole;
filling the first transparent ceramic piece in the first through hole;
filling the second transparent ceramic piece in the second through hole; and
sintering the first transparent ceramic piece, the second transparent ceramic piece, and the ceramic substrate to form the ceramic piece of an integrated structure.

## Patentansprüche

1. Gehäuse, umfassend mindestens ein Keramikbodengehäuse, eine Ladespule, ein Kunststoffinnengehäuse, eine nanokristalline Folie und eine Schutzfolie, wobei
die Ladespule an einer Innenseite des Keramikbodengehäuses angeordnet ist und die Ladespule eine gedruckte Spule ist und mit dem Keramikbodengehäuse zu einer integrierten Struktur gesintert ist;
die nanokristalline Folie eine Oberfläche der Ladespule bedeckt und fest mit der Ladespule verbunden ist;
die Schutzfolie eine Oberfläche der nanokristallinen Folie bedeckt und fest mit der nanokristallinen Folie verbunden ist und die Schutzfolie dazu ausgelegt ist, zu verhindern, dass die nanokristalline Folie beim Bilden des Kunststoffinnengehäuses durch Spritzgießen beschädigt wird; und
das Kunststoffinnengehäuse durch Nanospritzgießen an einer inneren Seitenfläche des Keramikbodengehäuses ausgebildet ist und die Schutzfolie bedeckt, so dass das Kunststoffinnengehäuse, das Keramikbodengehäuse und die Schutzfolie eine integrierte Struktur bilden.

2. Gehäuse nach Anspruch 1, wobei das Keramikbodengehäuse ein Keramikbodengehäuse ist, das durch Heißbiegen eines Keramikstücks gebildet ist.

3. Gehäuse nach Anspruch 1 oder 2, wobei ein Gegenabschnitt an dem Kunststoffinnengehäuse angeordnet ist, sich ein Klemmabschnitt an einem Rand der inneren Seitenfläche des Keramikbodengehäuses erstreckt, der Klemmabschnitt mit dem Gegenabschnitt verklemmt ist und die Ladespule an der inneren Seitenfläche des Keramikbodengehäuses angeordnet ist.

4. Gehäuse nach Anspruch 3, wobei der Klemmabschnitt und die innere Seitenfläche des Keramikbodengehäuses gemeinsam eine erste Stufenfläche definieren und der Gegenabschnitt eine Klemmnut zum Einsetzen des Klemmabschnitts ist.

5. Gehäuse nach einem der Ansprüche 1 bis 4, wobei sich ein vorstehender Abschnitt in der Mitte der inneren Seitenfläche des Keramikbodengehäuses erstreckt und der vorstehende Abschnitt und die innere Seitenfläche des Keramikbodengehäuses gemeinsam eine zweite Stufenfläche definieren; und
die Ladespule an der inneren Seitenfläche des Keramikbodengehäuses angeordnet ist und nahe der zweiten Stufenfläche angeordnet ist.

6. Gehäuse nach einem der Ansprüche 1 bis 5, wobei das Gehäuse ferner eine transparente Abdeckplatte umfasst, wobei ein Montagedurchgangsloch, das das Keramikbodengehäuse durchdringt, in der Mitte des Keramikbodengehäuses angeordnet ist, eine dritte Stufenfläche an einer Innenwand des Montagedurchgangslochs definiert ist und die transparente Abdeckplatte an der dritten Stufenfläche montiert ist.

7. Gehäuse nach einem der Ansprüche 1 bis 5, wobei das Keramikbodengehäuse einen Verbindungsabschnitt und einen transparenten Abschnitt umfasst; und
ein Material des Verbindungsabschnitts ein nicht transparentes Keramikmaterial ist und der transparente Abschnitt aus transparenter Keramik besteht und mit dem Verbindungsabschnitt zu einer integrierten Struktur gesintert ist.

8. Gehäuse nach Anspruch 7, wobei der transparente Abschnitt einen ersten transparenten Abschnitt und einen ringförmigen zweiten transparenten Abschnitt umfasst; und
der erste transparente Abschnitt sich in dem zweiten transparenten Abschnitt befindet und der erste transparente Abschnitt und der zweite transparente Abschnitt gemeinsam einen Ringspalt zur Aufnahme eines Teils des Verbindungsabschnitts definieren.

9. Gehäuse nach einem der Ansprüche 1 bis 8, wobei ein Material der gedruckten Spule Nanosilberpaste oder leitfähige Keramik ist; und
wenn das Material der gedruckten Spule leitfähige Keramik ist, die gedruckte Spule von dem Keramikbodengehäuse isoliert und mit dem Keramikbodengehäuse zu einer integrierten Struktur gesintert ist.

10. Gehäuse nach Anspruch 9, wobei die Schutzfolie eine Metallfolie ist oder die Schutzfolie eine Nichtmetallfolie aus Kunststoff oder Faser ist.

11. Tragbare Vorrichtung, umfassend ein leitfähiges Element und das Gehäuse nach einem der Ansprüche 1 bis 10, wobei eine Ladespule des Gehäuses über das leitfähige Element elektrisch mit einer Host-Schaltung der tragbaren Vorrichtung verbunden ist.

12. Herstellungsverfahren für ein Gehäuse, umfassend:
Bilden einer Ladespule, die mit einem Keramikbodengehäuse eine integrierte Struktur bildet, auf einer Innenfläche des Keramikbodengehäuses;
Abdecken einer Oberfläche der Ladespule mit einer nanokristallinen Folie;
Abdecken einer Oberfläche der nanokristallinen Folie mit einer Schutzfolie, um eine Bodengehäuseanordnung zu bilden; und
Einlegen der Bodengehäuseanordnung mit der Schutzfolie in eine Form zum Nanospritzgießen, um ein Kunststoffinnengehäuse zu bilden, das mit der Schutzfolie und dem Keramikbodengehäuse eine integrierte Struktur bildet.

13. Herstellungsverfahren nach Anspruch 12,
wobei das Bilden einer Ladespule, die mit einem Keramikbodengehäuse eine integrierte Struktur bildet, auf einer Innenfläche des Keramikbodengehäuses Folgendes umfasst:
Bereitstellen einer leitfähigen Paste;
Beschichten der Innenfläche des Keramikbodengehäuses mit der leitfähigen Paste unter Verwendung eines Druckverfahrens, um die Ladespule auf dem Keramikbodengehäuse zu bilden; und
Sintern des Keramikbodengehäuses mit der Ladespule, so dass die Ladespule und das Keramikbodengehäuse eine integrierte Struktur bilden.

14. Herstellungsverfahren nach Anspruch 13, wobei die leitfähige Paste Nanosilberpaste oder leitfähige Keramik ist.

15. Herstellungsverfahren nach Anspruch 13 oder 14, wobei das Druckverfahren eines der folgenden Verfahren umfasst: ein Siebdruckverfahren, ein Tampondruckverfahren, ein 3D-Druckverfahren, ein Aufkleberdruckverfahren und ein Gelblichtentwicklungsverfahren.

16. Herstellungsverfahren nach einem der Ansprüche 12 bis 15, wobei das Verfahren vor dem Bilden einer Ladespule, die mit einem Keramikbodengehäuse eine integrierte Struktur bildet, auf einer Innenfläche des Keramikbodengehäuses ferner Folgendes umfasst:
Herstellen des durch Heißbiegen gebildeten Keramikbodengehäuses.

17. Herstellungsverfahren nach Anspruch 16, wobei das Herstellen des durch Heißbiegen gebildeten Keramikbodengehäuses Folgendes umfasst:
Bereitstellen eines Keramikstücks mit gleichmäßiger Dicke;
Herstellen einer Stufenstruktur auf dem Keramikstück; und
Durchführen einer Heißbiegebearbeitung an dem Keramikstück mit der Stufenstruktur, um das Keramikbodengehäuse zu bilden.

18. Herstellungsverfahren nach Anspruch 17, wobei das Herstellen einer Stufenstruktur auf dem Keramikstück Folgendes umfasst:
Bilden einer ersten Ringnut auf einer Bodenfläche des Keramikstücks, wobei eine erste Stufenfläche und eine zweite Stufenfläche, die in radialer Richtung voneinander beabstandet sind, an einer Innenwand der ersten Ringnut gebildet sind und die zweite Stufenfläche nahe einer Achse der ersten Ringnut angeordnet ist; und
Bilden eines Montagedurchgangslochs, das das Keramikstück durchdringt, wobei sich das Montagedurchgangsloch in der ersten Ringnut befindet und nahe der zweiten Stufenfläche angeordnet ist, und eine dritte Stufenfläche an einer Innenwand des Montagedurchgangslochs definiert ist.

19. Herstellungsverfahren nach Anspruch 17, wobei das Herstellen einer Stufenstruktur auf dem Keramikstück Folgendes umfasst:
Bilden einer zweiten Ringnut auf einer Bodenfläche des Keramikstücks, wobei eine erste Stufenfläche und eine zweite Stufenfläche, die in radialer Richtung voneinander beabstandet sind, an einer Innenwand der zweiten Ringnut gebildet sind und die zweite Stufenfläche nahe einer Achse der zweiten Ringnut angeordnet ist.

20. Herstellungsverfahren nach Anspruch 17, wobei das Bereitstellen eines Keramikstücks mit gleichmäßiger Dicke Folgendes umfasst:
Bereitstellen eines nicht transparenten Keramiksubstrats, eines kreisförmigen ersten transparenten Keramikstücks und eines ringförmigen zweiten transparenten Keramikstücks;
Bilden eines ersten Durchgangslochs und eines ringförmigen zweiten Durchgangslochs, die das Keramiksubstrat durchdringen, wobei sich das erste Durchgangsloch in dem zweiten Durchgangsloch befindet;
Einbringen des ersten transparenten Keramikstücks in das erste Durchgangsloch;
Einbringen des zweiten transparenten Keramikstücks in das zweite Durchgangsloch; und
Sintern des ersten transparenten Keramikstücks, des zweiten transparenten Keramikstücks und des Keramiksubstrats, um das Keramikstück mit integrierter Struktur zu bilden.

## Revendications

1. Boîtier, comprenant au moins un boîtier de base en céramique, une bobine de charge, un boîtier intérieur en plastique, un film nanocristallin et un film protecteur, dans lequel
la bobine de charge est disposée sur un côté intérieur du boîtier de base en céramique, et la bobine de charge est une bobine imprimée et est frittée avec le boîtier de base en céramique en une structure intégrée ;
le film nanocristallin recouvre une surface de la bobine de charge et est solidement relié à la bobine de charge ;
le film protecteur recouvre une surface du film nanocristallin et est solidement relié au film nanocristallin, et le film protecteur est conçu pour empêcher que le film nanocristallin soit endommagé lors d'un procédé de formation du boîtier intérieur en plastique par moulage par injection ; et
le boîtier intérieur en plastique est formé sur une surface latérale intérieure du boîtier de base en céramique par moulage par nano-injection et recouvre le film protecteur, de sorte que le boîtier intérieur en plastique, le boîtier de base en céramique et le film protecteur font partie d'une structure intégrée.

2. Boîtier selon la revendication 1, dans lequel le boîtier de base en céramique est un boîtier de base en céramique formé par pliage à chaud d'une pièce en céramique.

3. Boîtier selon la revendication 1 ou 2, dans lequel une partie d'assemblage est disposée sur le boîtier intérieur en plastique, une partie de serrage est disposée de manière à se prolonger au niveau d'un bord de la surface latérale intérieure du boîtier de base en céramique, la partie de serrage est serrée sur la partie d'assemblage, et la bobine de charge est disposée sur la surface latérale intérieure du boîtier de base en céramique.

4. Boîtier selon la revendication 3, dans lequel la partie de serrage et la surface latérale intérieure du boîtier de base en céramique définissent conjointement une première surface étagée, et la partie d'assemblage est une rainure de serrage destinée à insérer la partie de serrage.

5. Boîtier selon l'une quelconque des revendications 1 à 4, dans lequel une partie saillante est disposée de manière à se prolonger au milieu de la surface latérale intérieure du boîtier de base en céramique, et la partie saillante et la surface latérale intérieure du boîtier de base en céramique définissent conjointement une deuxième surface étagée ; et
la bobine de charge est disposée sur la surface latérale intérieure du boîtier de base en céramique et est disposée près de la deuxième surface étagée.

6. Boîtier selon l'une quelconque des revendications 1 à 5, le boîtier comprenant en outre une plaque de recouvrement transparente, un trou traversant de montage qui pénètre dans le boîtier de base en céramique étant disposé au milieu du boîtier de base en céramique, une troisième surface étagée étant définie sur une paroi intérieure du trou traversant de montage, et la plaque de recouvrement transparente étant montée sur la troisième surface étagée.

7. Boîtier selon l'une quelconque des revendications 1 à 5, dans lequel le boîtier de base en céramique comprend une partie de raccordement et une partie transparente ; et
un matériau de la partie de raccordement est un matériau céramique non transparent, et la partie transparente est une céramique transparente et est frittée avec la partie de raccordement en une structure intégrée.

8. Boîtier selon la revendication 7, dans lequel la partie transparente comprend une première partie transparente et une deuxième partie transparente annulaire ; et
la première partie transparente est située dans la deuxième partie transparente, et la première partie transparente et la deuxième partie transparente définissent conjointement un espace annulaire destiné à accueillir une portion de la partie de raccordement.

9. Boîtier selon l'une quelconque des revendications 1 à 8, dans lequel un matériau de la bobine imprimée est une pâte de nanoargent ou une céramique conductrice ; et
lorsque le matériau de la bobine imprimée est la céramique conductrice, la bobine imprimée est isolée du boîtier de base en céramique et est frittée avec le boîtier de base en céramique en une structure intégrée.

10. Boîtier selon la revendication 9, dans lequel le film protecteur est un film métallique, ou bien le film protecteur est un film non métallique constitué de plastique ou de fibres.

11. Dispositif portable, comprenant un élément conducteur et le boîtier selon l'une quelconque des revendications 1 à 10, une bobine de charge du boîtier étant reliée électriquement à un circuit hôte du dispositif portable par le biais de l'élément conducteur.

12. Procédé de préparation d'un boîtier, comprenant :
la formation, sur une surface intérieure d'un boîtier de base en céramique, d'une bobine de charge qui fait partie d'une structure intégrée avec le boîtier de base en céramique ;
le revêtement d'une surface de la bobine de charge avec un film nanocristallin ;
le revêtement d'une surface du film nanocristallin avec un film protecteur pour former un ensemble boîtier de base ; et
la mise en place de l'ensemble boîtier de base pourvu du film protecteur à l'intérieur d'un moule pour un moulage par nano-injection, afin de former un boîtier intérieur en plastique qui fait partie d'une structure intégrée avec le film protecteur et le boîtier de base en céramique.

13. Procédé de préparation selon la revendication 12,
dans lequel la formation, sur une surface intérieure d'un boîtier de base en céramique, d'une bobine de charge qui fait partie d'une structure intégrée avec le boîtier de base en céramique comprend :
l'obtention d'une suspension conductrice ;
le dépôt de la suspension conductrice sur la surface intérieure du boîtier de base en céramique au moyen d'un procédé d'impression, pour former la bobine de charge sur le boîtier de base en céramique ; et
le frittage du boîtier de base en céramique pourvu de la bobine de charge de telle sorte que la bobine de charge et le boîtier de base en céramique forment une structure intégrée.

14. Procédé de préparation selon la revendication 13, dans lequel la suspension conductrice est une pâte de nanoargent ou une céramique conductrice.

15. Procédé de préparation selon la revendication 13 ou 14, dans lequel le procédé d'impression comprend n'importe lequel des procédés suivants : un procédé de sérigraphie, un procédé de tampographie, un procédé d'impression 3D, un procédé d'impression par autocollant, et un procédé de développement sous lumière jaune.

16. Procédé de préparation selon l'une quelconque des revendications 12 à 15, le procédé comprenant en outre, avant la formation, sur une surface intérieure d'un boîtier de base en céramique, d'une bobine de charge qui fait partie d'une structure intégrée avec le boîtier de base en céramique :
la préparation du boîtier de base en céramique formé par pliage à chaud.

17. Procédé de préparation selon la revendication 16, dans lequel la préparation du boîtier de base en céramique formé par pliage à chaud comprend :
l'obtention d'une pièce en céramique présentant une épaisseur uniforme ;
la préparation d'une structure étagée sur la pièce en céramique ; et
la réalisation d'un traitement de pliage à chaud sur la pièce en céramique pourvu de la structure étagée pour former le boîtier de base en céramique.

18. Procédé de préparation selon la revendication 17, dans lequel la préparation d'une structure étagée sur la pièce en céramique comprend :
la formation d'une première rainure annulaire sur une surface inférieure de la pièce en céramique, une première surface étagée et une deuxième surface étagée qui sont espacées le long d'une direction radiale étant formées sur une paroi intérieure de la première rainure annulaire, et la deuxième surface étagée étant disposée près d'un axe de la première rainure annulaire ; et
la formation d'un trou traversant de montage qui pénètre dans la pièce en céramique, le trou traversant de montage étant situé dans la première rainure annulaire et étant disposé près de la deuxième surface étagée, et une troisième surface étagée étant définie sur une paroi intérieure du trou traversant de montage.

19. Procédé de préparation selon la revendication 17, dans lequel la préparation d'une structure étagée sur la pièce en céramique comprend :
la formation d'une deuxième rainure annulaire sur une surface inférieure de la pièce en céramique, une première surface étagée et une deuxième surface étagée qui sont espacées le long d'une direction radiale étant formées sur une paroi intérieure de la deuxième rainure annulaire, et la deuxième surface étagée étant disposée près d'un axe de la deuxième rainure annulaire.

20. Procédé de préparation selon la revendication 17, dans lequel l'obtention d'une pièce en céramique présentant une épaisseur uniforme comprend :
l'obtention d'un substrat en céramique non transparent, d'une première pièce en céramique transparente circulaire, et d'une deuxième pièce en céramique transparente annulaire ;
la formation d'un premier trou traversant et d'un deuxième trou traversant annulaire qui pénètrent dans le substrat en céramique, le premier trou traversant étant situé dans le deuxième trou traversant ;
le remplissage avec la première pièce en céramique transparente du premier trou traversant ;
le remplissage avec la deuxième pièce en céramique transparente du deuxième trou traversant ; et
le frittage de la première pièce en céramique transparente, de la deuxième pièce en céramique transparente et du substrat en céramique pour former la pièce en céramique de structure intégrée.
